# EUROPÄISCHE PATENTSCHRIFT

(11) **EP 2 077 705 B1**
(45) Veröffentlichungstag und Bekanntmachung des Hinweises auf die Patenterteilung: **23.10.2019**
(21) Anmeldenummer: 08171851.2
(22) Anmeldetag: 16.12.2008
(51) Int. Cl.: H05K 7/14

(54) **Varioträger zur Montage an zwei vertikalen Trägerprofilen eines Racks sowie Montageverfahren**
Variable loader for mounting on two vertical loading profiles of a rack and mounting method
Support variable destiné au montage sur deux profilés de support verticaux d'un rack et procédé de montage

(30) Priorität: 03.01.2008 DE 102008003071
(43) Veröffentlichungstag der Anmeldung: 08.07.2009
(73) Patentinhaber: Fujitsu Limited, Kawasaki-shi Kanagawa 211-8588 (JP)
(72) Erfinder: Köhler, Friedrich, 86405, Meitingen (DE); Schelshorn, Lorenz, 86179, Augsburg (DE)
(74) Vertreter: Epping - Hermann - Fischer

(56) Entgegenhaltungen:
- DE-U1-202007 012 830
- US-A1- 2001 040 203
- US-A1- 2006 152 115
- US-A1- 2006 283 816

## Beschreibung

Die Erfindung betrifft einen Varioträger zur Montage an zwei vertikalen Trägerprofilen eines Racks, wobei die vertikalen Trägerprofile des Racks Öffnungen in einem standardisierten Raster aufweisen, der Varioträger über die Öffnungen an den vertikalen Trägerprofilen festlegbar ist und der Varioträger eine Rasteinrichtung aufweist, welche bei der Montage in einer der Öffnungen an den vertikalen Trägerprofilen automatisch verrastet.

Ferner betrifft die Erfindung ein Verfahren zur Montage eines Varioträgers an zwei vertikalen Trägerprofilen eines Racks. Weiterhin wird eine Anordnung eines solchen Varioträgers und eines solchen Racks beschrieben.

Zum Einbau eines Computerservers oder einer anderen Komponente in einem Rack wird ein Systemträger (Rack Mount Kit, RMK) benötigt. Dieser Systemträger ermöglicht es, einen Computerserver für Wartungsarbeiten ohne die Demontage der Befestigungselemente aus dem Rack zu ziehen. Der Systemträger besteht aus einem linken und einem rechten Träger. Der Varioträger ist eine Variante davon, die eine vom Benutzer einstellbare Länge ermöglicht, wobei die Länge sich nach dem Abstand zwischen den Trägerprofilen eines Racks richtet.

Die Öffnungen in den vertikalen Trägerprofilen weisen in Europa quadratische Öffnungen mit einem Maß von 9 x 9 mm beziehungsweise 9,5 x 9,5 mm auf. In den USA sind die Öffnungen ebenfalls standardisiert, wobei hier ein Rundlochraster verwendet wird. Bisher werden die Trägersysteme beziehungsweise die Varioträger manuell mit den vertikalen Trägerprofilen verschraubt. Um die Montage zu vereinfachen, ist es wünschenswert, die Varioträger auch ohne Schrauben an den vertikalen Trägerprofilen der Racks befestigen zu können.

Aus der US 6,659,577 B2 ist ein System bekannt, bei dem an dem Varioträger ein Winkel mit nach innen weisenden Vorsprüngen angeschraubt ist, welcher von außen in die Öffnungen der vertikalen Trägerprofile gesteckt werden kann. Um ein Herausrutschen der Fortsätze aus den Öffnungen zu verhindern, wird von innen ein Anschlag in Position gebracht und mit einer Schraube fixiert.

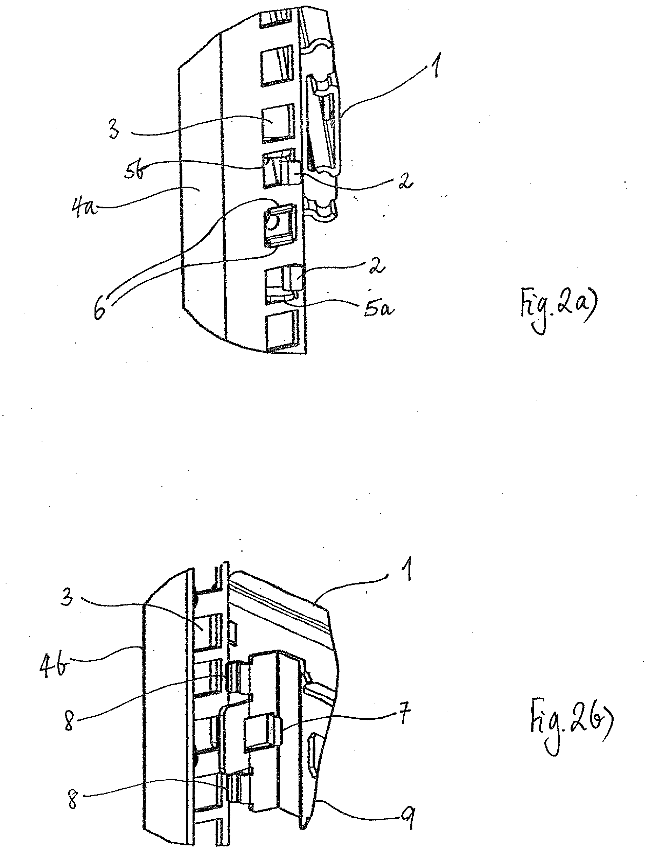

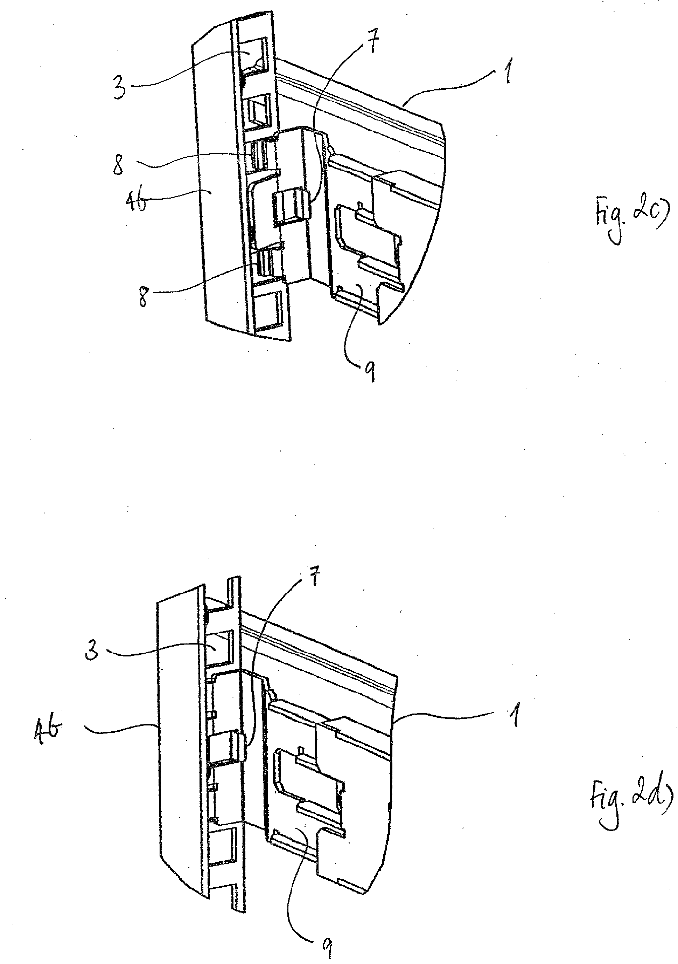

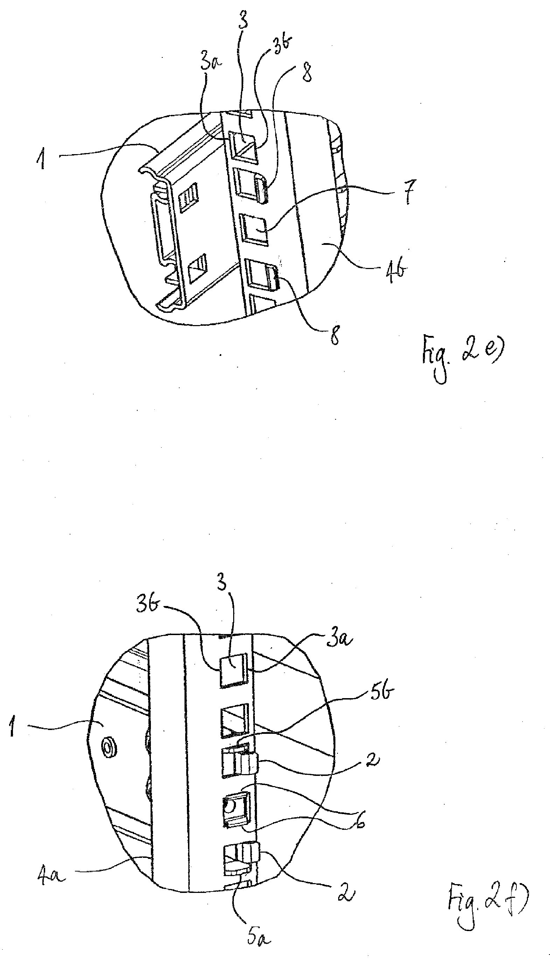

Die US 6,230,903 B1 offenbart eine alternative Lösung für eine schraubenlose Montage eines Varioträgers. Gemäß der Ausführungsform nach Figur 2 der Druckschrift werden an einer Teleskopschiene zwei Schienen angeschraubt, welche ebenfalls endseitig nach innen vorspringende Fortsätze aufweisen und in die Öffnungen der vertikalen Trägerprofile von außen eingreifen können. Um ein Herausrutschen der Fortsätze aus den Öffnungen der vertikalen Trägerprofile zu vermeiden, werden die Schienen an einem durchgehend starren Teil der Teleskopschiene fixiert. Das Ausführungsbeispiel gemäß Figur 5 der Druckschrift ist prinzipiell analog aufgebaut, wobei hier die Fortsätze von innen nach außen weisen, sodass sie auch in dieser Richtung durch die Öffnungen in die vertikalen Trägerprofile zur Festlegung der Teleskopschiene gesteckt werden.

Nachteilig an diesen beiden Lösungen ist immer noch die relativ aufwändige Montage, da bei der US 6,659,577 ein Anschlag angeschraubt werden muss, und bei der US 6,230,903 die Schienen an durchgehenden Teilen der Teleskopschiene befestigt werden müssen. Dies geschieht jeweils immer in eingestecktem Zustand der Vorsprünge in den Öffnungen. Bei dieser Verschraubung besteht die Gefahr, dass die Vorsprünge wieder aus den Öffnungen rutschen, sodass man bei der Montage vor dem festen Verschrauben bei leicht angezogenen Schrauben noch mal überprüfen muss, ob die Vorsprünge komplett in die Öffnungen eingreifen.

Aus der DE 202007012830.4 ist auch ein schraubenloses System bekannt, bei dem der Varioträger eine Rasteinrichtung aufweist, welche beim Einstecken in eine der Öffnungen an den vertikalen Trägerprofilen automatisch verrastet. Die Rasteinrichtung ist an einer Stirnseite des Varioträgers angeordnet und ist als federbelasteter Haken ausgebildet, der bei der Montage des Varioträgers von innen durch eine Öffnung des vertikalen Trägerprofils gesteckt wird und im montierten Zustand hinter den Rand der Öffnung greift. Auf der gegenüberliegenden Stirnseite des Varioträgers ist eine weitere Rasteinrichtung oder ein hervorstehender Balken angeordnet, der in die Öffnung des vertikalen Trägerprofils eingesteckt werden kann. Bei der Montage wird zuerst ein Ende des Varioträgers in die Öffnungen des vertikalen Trägerprofils eingesteckt und dann das zweite Ende durch die verstellbare Länge des Varioträgers eingesteckt.

Nachteilig an dieser Lösung ist die Gefahr des Herausrutschens des Endes mit dem hervorstehenden Balken. Hier muss die Länge des Varioträgers sehr genau eingestellt und gut fixiert werden. Wenn der Varioträger an beiden Stirnseiten eine Rasteinrichtung aufweist, kann der Varioträger zwar nicht mehr aus den Öffnungen herausrutschen, die Herstellung des Varioträgers ist jedoch aufgrund der Vielzahl von beweglichen Teilen aufwändiger geworden. Weitere Lösungen zur Montage eines Varioträgers an einem Rack sind aus den Druckschriften US 2001/0040203 A1, US 2006/0283816 A1 und US 2006/0152115 A1 bekannt. Auch bei diesen Lösungen kann ein Varioträger über Rasteinrichtungen an vertikalen Trägerprofilen eines Racks montiert werden. Derartige Lösungen sind jedoch recht aufwändig in ihrer Konstruktion bzw. nachteilig hinsichtlich der Flexibilität oder Handhabung des Varioträgers während seiner Montage.

Der Erfindung liegt daher die Aufgabe zugrunde, eine Lösung für die Montage eines Varioträgers an vertikalen Trägerprofilen eines Racks zu beschreiben, die eine einfachere Herstellung und eine leichtere Montage des Varioträgers erlaubt.

Diese Aufgabe wird erfindungsgemäß dadurch gelöst, dass der Varioträger gegenüberliegend der Rasteinrichtung zumindest einen starr mit dem Varioträger verbundenen Haltehaken zum Einhängen in eine der Öffnungen eines vertikalen Trägerprofils aufweist, so dass der Varioträger über den Haltehaken in die Öffnung eingehängt werden kann, wobei der Haltehaken im montierten Zustand seitlich hinter einen vertikalen Rand der dafür vorgesehenen Öffnung des vertikalen Trägerprofils greift. Weiterhin weist der Varioträger einen federnden Längenausgleich auf, wobei der federnde Längenausgleich gespannt werden kann und der Varioträger um den Haltehaken in einer horizontalen Ebene in Richtung des gegenüberliegenden vertikalen Trägerprofils geschwenkt werden kann und anschließend der federnde Längenausgleich entspannt werden kann und die
Rasteinrichtung mit einer der Öffnungen am gegenüberliegenden vertikalen Trägerprofil verrasten kann.

Durch den starr mit dem Varioträger verbundenen Haltehaken ist der Varioträger gegen ein Herausrutschen aus den Öffnungen der vertikalen Trägerprofile gut gesichert. Im montierten Zustand greift der Haltehaken, seitlich hinter einen vertikalen Rand der dafür vorgesehenen Öffnung des vertikalen Trägerprofils. Damit wird eine zusätzliche Rasteinrichtung an dem Varioträger, welche mit zusätzlichem Herstellungsaufwand und damit auch zusätzlichen Herstellungskosten verbunden wäre, überflüssig.

Vorzugsweise wird der Varioträger in einem spitzen Winkel zu einer imaginären Achse Y-Y', die zwischen den zwei vertikalen Trägerprofilen verläuft, gehalten, so dass der Haltehaken durch die Öffnung des ersten vertikalen Trägerprofils geführt werden kann. Der Varioträger wird weiterhin um diesen Haltehaken in einer horizontalen Ebene bewegt bzw. geschwenkt, wobei das zweite Ende des Varioträgers, das eine Rasteinrichtung aufweist, in die Nähe des zweiten vertikalen Trägerprofils gebracht wird. Das heißt, dass sich das zweite Ende des Varioträgers entlang einer Kreisbahn bewegt, wobei das Zentrum des Kreises der Haltehaken ist.

Der Varioträger ist vorzugsweise mit einem federnden Längenausgleich ausgestattet. Wenn das zweite Ende des Varioträgers kurz vor dem zweiten vertikalen Trägerprofil steht, und der Varioträger fast auf der Achse Y-Y' steht, wird der Längenausgleich gespannt und das zweite Ende des Varioträgers weiter geschwenkt, bis die Rasteinrichtung in eine Öffnung des zweiten vertikalen Trägerprofils einrastet. Nach dem Einschwenken wird der Längenausgleich vorzugsweise entspannt. Durch eine Verschlussfeder, welche in dem vertikalen Trägerprofil einrastet, wird ein erneutes Entriegeln des Längenausgleichs verhindert.

Der Varioträger weist bevorzugt an den beiden Stirnseiten Haltehaken auf, die starr mit dem Varioträger verbunden sind. Die zwei Stirnseiten des Varioträgers befinden sich an den beiden Enden des Varioträgers und sind die Vorderflächen des Varioträgers, die jeweils nach außen in Richtung der größten Dimension der Varioträgers, nämlich der Länge, gerichtet sind. Vorzugsweise greifen die Haltehaken an der einen Stirnseite seitlich in eine Richtung und die Haltehaken an der anderen Stirnseite seitlich in die Gegenrichtung. Damit sind die Haltehaken derart gerichtet, dass der Varioträger am einen Ende in einem ersten vertikalen Trägerprofil eingehängt werden kann und dann in einer horizontalen Ebene geschwenkt werden kann, bis das andere, zweite Ende kurz vor dem zweiten vertikalen Trägerprofil steht. Die Haltehaken an dem zweiten Ende des Varioträgers sind in Schwenkrichtung gerichtet. Bevorzugt ist zumindest ein Zentrierelement an der der Rasteinrichtung gegenüberliegenden Stirnseite angeordnet. Während des Einschwenkens des Varioträgers wird das Zentrierelement durch eine Öffnung des vertikalen Trägerprofils geführt. Das Zentrierelement verhindert ein Herausrutschen der Haltehaken und sonstige Bewegungen des Varioträgers relativ zum ersten vertikalen Trägerprofil. Das Zentrierelement ist bevorzugt als horizontale Lasche ausgebildet, wobei die der Rasteinrichtung gegenüberliegenden Haltehaken vertikal in die Öffnungen des vertikalen Trägerprofils eingreifen.

Vorzugsweise ist die Rasteinrichtung als Feder-Element ausgebildet, das im verrasteten Zustand entspannt ist und an einem vertikalen Rand einer Öffnung des zweiten vertikalen Trägerprofils anschlägt. Damit dient das Feder-Element auch der Stabilisierung des Varioträgers relativ zum vertikalen Trägerprofil.

Die der Erfindung zugrunde liegende Aufgabe wird ebenso durch ein Montageverfahren nach Anspruch 7 gelöst.

Weitere Vorteile der Erfindung beziehungsweise vorteilhafte Ausgestaltungen ergeben sich aus den Unteransprüchen sowie den nachfolgenden Figurenbeschreibungen.

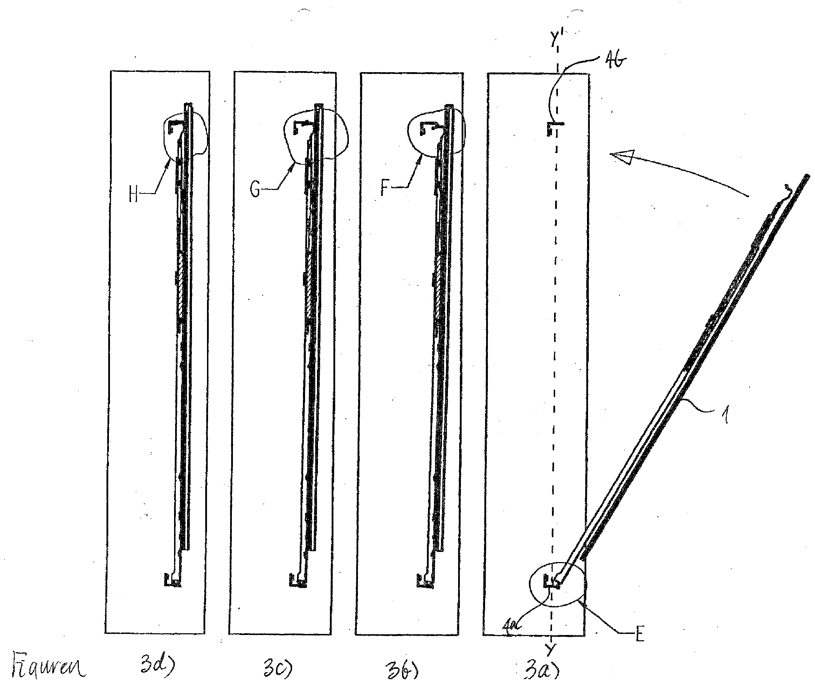

Nachfolgend wird anhand eines in den Figuren dargestellten Ausführungsbeispiels die Erfindung näher erläutert. In den Figuren zeigen:

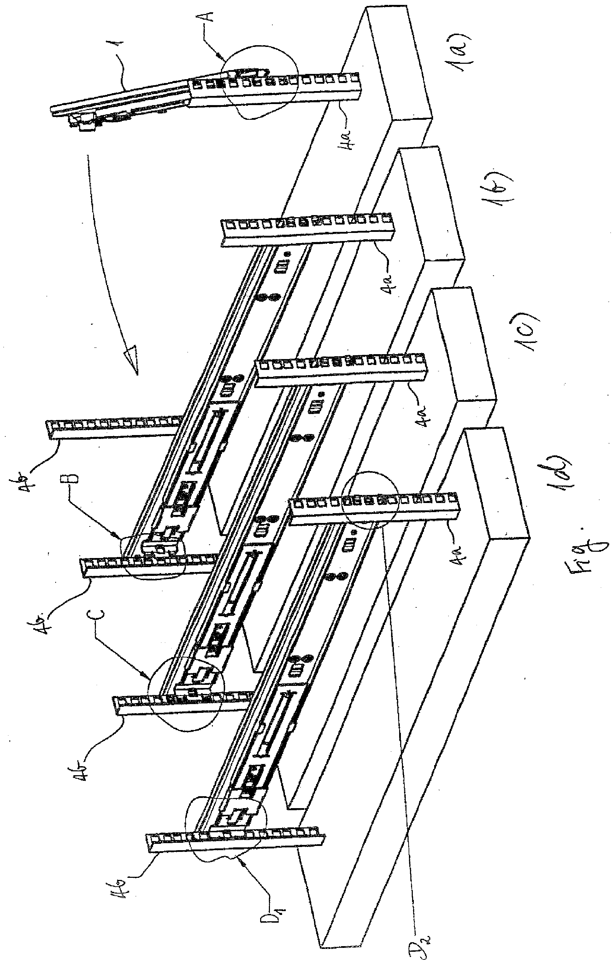

- Figuren 1a bis 1d: jeweils eine perspektivische Darstellung eines Varioträgers und zweier vertikaler Trägerprofile eines Racks bei verschiedenen Schritten des Montageverfahrens,
- Figuren: 2a bis 2f jeweils einen vergrößerten Ausschnitt eines Endes des Varioträgers und des jeweiligen vertikalen Trägerprofils gemäß den Figuren 1a bis 1d,
- Figuren: 3a bis 3d jeweils eine zweidimensionale Draufsicht eines Varioträgers und zwei Trägerprofile bei verschiedenen Schritten des Montageverfahrens und
- Figuren: 4a bis 4e jeweils einen vergrößerten Ausschnitt eines Endes des Varioträgers und des jeweiligen vertikalen Trägerprofils gemäß den Figuren 3a bis 3d.

In Figur 1a ist ein Varioträger 1 an einem ersten Ende mittels zweier starr mit dem Varioträger 1 verbundenen Haltehaken 2 in zwei Öffnungen 3 eines ersten vertikalen Trägerprofils 4a eingehängt. In dieser Stellung steht der Varioträger 1 in einem spitzen Winkel von einer imaginären Achse Y-Y' ab, die zwischen zwei vertikalen Trägerprofilen 4a, 4b verläuft. Der Varioträger 1 wird anschließend in Richtung des zweiten vertikalen Trägerprofils 4b in einer horizontalen Ebene geschwenkt, wie in Figur 1a mit einem Pfeil angedeutet ist.

Ein vergrößerter Ausschnitt A der in den Öffnungen 3 des vertikalen Trägerprofils 4a eingehängten Haltehaken 2 des Varioträgers 1 bei diesem Schritt des Montageverfahrens ist in Figur 2a dargestellt. Die zwei Haltehaken 2 sind von der Innenseite des vertikalen Trägerprofils 4a aus, also von der dem anderen vertikalen Trägerprofils 4b zugewandten Seite des Trägerprofils 4a aus, eingehängt. Figur 2a zeigt den Ausschnitt von der Außenseite des ersten vertikalen Trägerprofils 4a. Die zwei Haltehaken 2 greifen seitlich hinter jeweils einen vertikalen Rand der entsprechenden Öffnung 3 des vertikalen Trägerprofils 4a, sitzen aber noch nicht formschlüssig. Die Haltehaken 2 sind entgegen der Schwenkrichtung gerichtet, sodass sie durch das Schwenken fester bzw. formschlüssiger hinter den entsprechenden Rand der Öffnung 3 greifen und nicht gelockert werden.

Zur Stabilisierung beziehungsweise Zentrierung weist der Varioträger 1 auch an der Stirnseite zwei horizontale Laschen 5a und 5b auf, die durch die Öffnungen 3 des ersten vertikalen Trägerprofils 4a geführt werden. In diesem Beispiel werden die horizontalen Laschen 5a und 5b in die gleichen zwei Öffnungen 3 wie die Haltehaken 2 geführt. Idealerweise liegt die untere horizontale Lasche 5a an dem unteren Rand der unteren Öffnung 3 an und die obere horizontale Lasche 5b an dem oberen Rand der oberen Öffnung 3 an. Somit ist der Varioträger 1 sowohl in der Vertikalen als auch in der Horizontalen stabilisiert. Optional kann als zusätzliche Sicherung gegen das Herausrutschen der Haltehaken 2 eine Sperrklinke 6 an dieser Stirnseite des Varioträgers 1 eingebaut werden.

Der Varioträger 1 wird zunächst gemäß Figur 1a in Pfeilrichtung in einer horizontalen Ebene geschwenkt, bis der Varioträger 1 nahezu an der imaginären Achse Y-Y' steht. Diese Stellung ist in Figur 1b dargestellt. Das den Haltehaken gegenüberliegende Ende des Varioträgers, welches eine Rasteinrichtung aufweist, steht kurz vor der Innenseite des zweiten Trägerprofils 4b.

Ein vergrößerter Ausschnitt B des die Rasteinrichtung aufweisenden Endes des Varioträgers 1 ist in Figur 2b dargestellt. Die Rasteinrichtung weist ein Federelement 7 und zwei starr mit dem Varioträger 1 verbundene Haltehaken 8 auf. Der Varioträger 1 ist ferner mit einem federnden Längenausgleich 9 ausgestattet. Bei diesem Schritt des Montageverfahrens wird der Längenausgleich 9 gespannt, sodass die Haltehaken 8 der Rasteinrichtung durch zwei entsprechende Öffnungen 3 des zweiten vertikalen Trägerprofils 4b geführt werden können.

Dieser weitere Schritt ist in Figur 1c und als vergrößerter Ausschnitt C in Figur 2c dargestellt. Die Stirnseite des Varioträgers 1 liegt nun an der Innenseite des zweiten vertikalen Trägerprofils 4b an. Der vertikale Rand einer Öffnung 3 eines vertikalen Trägerprofils 4a oder 4b, der dem Varioträger 1 am Nächsten liegt, wird als äußerer vertikaler Rand 3a bezeichnet. Der dem äußeren Rand gegenüberliegende vertikale Rand einer Öffnung 3 wird als innerer vertikaler Rand 3b bezeichnet. Die Haltehaken 8 sind so gerichtet, dass sie in der Schwenkrichtung jeweils seitlich hinter einen vertikalen Rand 3b der Öffnungen 3 greifen können. In der Position gemäß Figur 2c greifen die Haltehaken 8 jedoch noch nicht hinter den jeweiligen Rand 3b der Öffnungen 3, sondern liegen an dem diesem gegenüberliegenden vertikalen Rand 3a der Öffnungen 3 an.

Schließlich wird der Varioträger 1 gemäß Figur 1d weiter geschwenkt, sodass das Feder-Element 7 gegen das vertikale Trägerprofil 4b gedrückt und somit gespannt wird, bis das Feder-Element 7 in eine dritte Öffnung des zweiten vertikalen Trägerprofils 4b einschnappt und wieder in einem entspannten Zustand ist. Das entspannte Feder-Element 7 liegt dann an dem äußeren vertikalen Rand 3a seiner Öffnung 3 an, wobei die zwei Haltehaken 8 der Rasteinrichtung jeweils hinter den inneren vertikalen Rand 3b ihrer entsprechenden Öffnungen 3 greifen. Somit ist auch die Stirnseite des Varioträgers 1, welche am vertikalen Trägerprofil 4b positioniert wurde, stabilisiert und verriegelt.

Der in Figur 1d mit D1 gekennzeichnete Ausschnitt ist in vergrößerter Form in Figur 2d dargestellt. Figur 2e zeigt den gleichen Ausschnitt D1, jedoch nun von der Außenseite des vertikalen Trägerprofils 4b aus betrachtet. Die Haltehaken 8 der Rasteinrichtung tauchen durch die Öffnungen 3 des vertikalen Trägerprofils 4b und hintergreifen nach dem Einrasten schließlich die Außenseite des vertikalen Trägerprofil 4b. Die Haltehaken 8 liegen dabei formschlüssig an einem inneren vertikalen Rand 3b ihrer entsprechenden Öffnungen 3 an. Das Feder-Element 7 liegt formschlüssig an dem gegenüberliegenden vertikalen Rand 3a seiner Öffnung 3 an.

Der in Figur 1d mit D2 gekennzeichnete Ausschnitt des ersten Trägerprofils 4a ist in vergrößerter Form in Figur 2f dargestellt. Hier ist die optionale Sperrklinke 6 eingeschnappt, wobei die Haltehaken 2 vollständig durch ihre Öffnungen 3 hindurch getaucht sind und den äußeren vertikalen Rand 3a der entsprechenden Öffnungen 3 formschlüssig hintergreifen. Die horizontalen Laschen 5a, 5b liegen an dem unteren Rand beziehungsweise oberen Rand der Öffnungen 3 an und stabilisieren den Varioträger 1 vertikal und horizontal. Die Montageverfahrensschritte der Figuren 1a bis 1d sowie 2a bis 2f sind noch mal in den Figuren 3a bis 3d dargestellt, jedoch nun in Draufsicht.

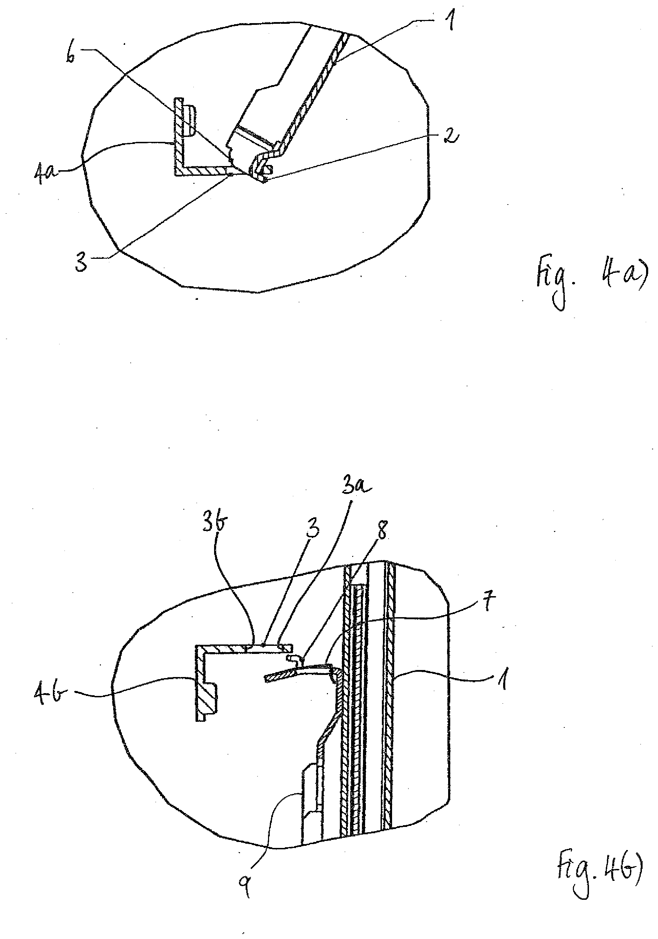

In Figur 3a wird, wie bereits beschrieben, der Varioträger 1 mittels der Haltehaken 2 in dem ersten vertikalen Trägerprofil 4a eingehängt, sodass der Varioträger 1 in einem spitzen Winkel von der imaginären Achse Y-Y' absteht, welche in Figur 3a strichliert angedeutet ist. Die Haltehaken 2 sind in entsprechende Öffnungen 3 des vertikalen Trägerprofils 4a eingehängt, liegen aber noch nicht formschlüssig an dem äußeren vertikalen Rand 3a ihrer Öffnungen 3 an. Der in Figur 3a mit E gekennzeichnete Ausschnitt ist in vergrößerter Form in Figur 4a dargestellt.

Nach dem Schwenken des Varioträgers 1 in Pfeilrichtung steht er nahezu auf der imaginären Achse Y-Y', wie in Figur 3b dargestellt ist. Der in Figur 3b mit F gekennzeichnete Ausschnitt ist in Figur 4b in vergrößerter Form dargestellt. Hier stehen die Haltehaken 8 der Rasteinrichtung kurz vor den entsprechenden Öffnungen 3 des zweiten vertikalen Trägerprofils 4b.

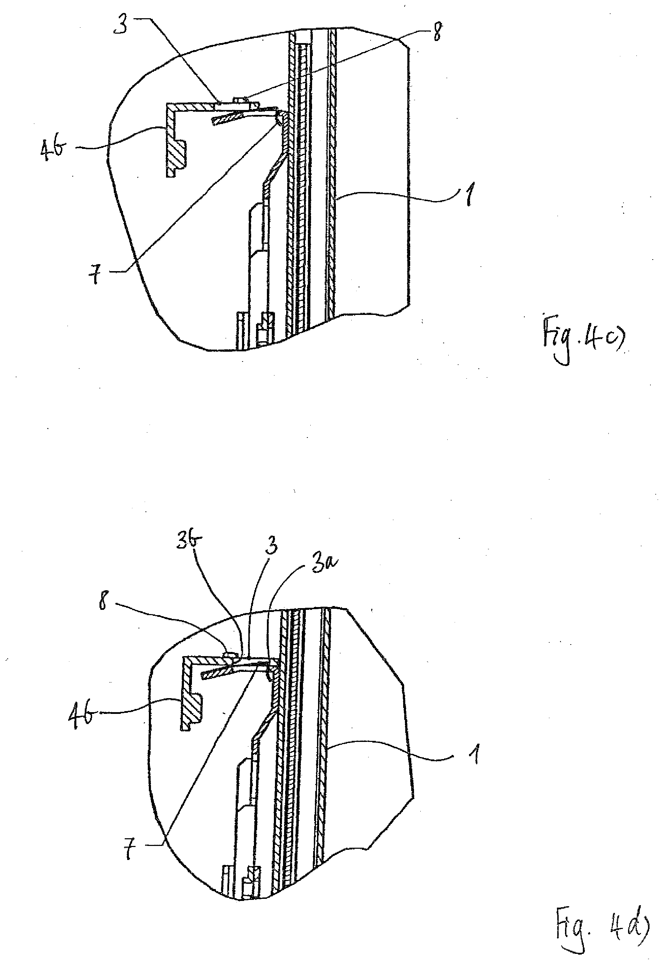

Durch weiteres Schwenken und Spannen des Längenausgleichs 9 des Varioträgers 1 werden die Haltehaken 8 durch die entsprechenden Öffnungen 3 geschoben, bis die Stirnseite des Varioträgers 1 an dem zweiten vertikalen Trägerprofil 4b liegt (siehe Figur 3c). Der in Figur 3c mit G gekennzeichnete Ausschnitt ist in Figur 4c in vergrößerter Form dargestellt. Das Feder-Element 7 ist hier noch in einem entspannten Zustand.

Durch weiteres Schwenken wird das Feder-Element 7 an das vertikale Trägerprofil 4b gedrückt und gespannt. Dabei bewegen sich die Haltehaken 8 in Richtung des inneren vertikalen Rands 3b der entsprechenden Öffnungen 3, bis sie dort anschlagen und das vertikale Trägerprofil 4b hintergreifen. Gleichzeitig schnappt das Feder-Element 7 in die Öffnung 3 ein. Das Feder-Element 7 liegt jetzt an dem äußeren vertikalen Rand 3a der entsprechenden Öffnung 3 an. Der Ausschnitt H aus Figur 3d ist vergrößert in Figur 4d dargestellt.

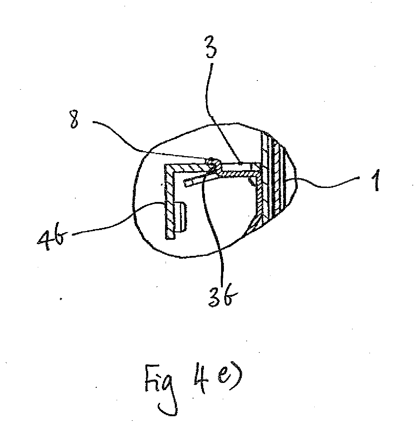

Ferner zeigt Figur 4e ein Schnittbild des Ausschnitts H zur deutlicheren Darstellung der verrasteten Position des Varioträgers 1 am vertikalen Trägerprofil 4b. Die Haltehaken 8 liegen am vertikalen Rand 3b ihrer Öffnungen 3 an und hintergreifen das vertikale Trägerprofil 4b.

### Bezugszeichenliste

- 1: Varioträger
- 2: Haltehaken
- 3: Öffnung eines vertikalen Trägerprofils
- 3a: äußerer vertikaler Rand einer Öffnung
- 3b: innerer vertikaler Rand einer Öffnung
- 4a,4b: vertikales Trägerprofil
- 5a,5b: horizontale Lasche
- 6: Sperrklinke
- 7: Feder-Element
- 8: Haltehaken der Rasteinrichtung
- 9: Längenausgleich

## Patentansprüche

1. Varioträger (1) zur Montage an zwei vertikalen Trägerprofilen (4a, 4b) eines Racks, wobei
- die zwei vertikalen Trägerprofile (4a, 4b) des Racks Öffnungen (3) in einem standardisierten Raster aufweisen,
- der Varioträger (1) über die Öffnungen (3) an den vertikalen Trägerprofilen (4a, 4b) festlegbar ist und
- der Varioträger (1) eine Rasteinrichtung aufweist, welche bei der Montage in einer der Öffnungen (3) an den vertikalen Trägerprofilen (4a, 4b) automatisch verrastbar ist,
**dadurch gekennzeichnet, dass**
der Varioträger (1)
- gegenüberliegend der Rasteinrichtung zumindest einen starr mit dem Varioträger (1) verbundenen Haltehaken (2) zum Einhängen in eine der Öffnungen (3) eines vertikalen Trägerprofils (4a) der zwei vertikalen Trägerprofile (4a, 4b) aufweist, so dass der Varioträger (1) über den Haltehaken (2) in die Öffnung (3) eingehängt werden kann, wobei der Haltehaken (2) im montierten Zustand seitlich hinter einen vertikalen Rand der dafür vorgesehenen Öffnung (3) des einen vertikalen Trägerprofils (4a) greift und
- einen federnden Längenausgleich (9) aufweist, wobei der federnde Längenausgleich (9) gespannt werden kann und der Varioträger (1) um den Haltehaken (2) in einer horizontalen Ebene in Richtung des gegenüberliegenden anderen vertikalen Trägerprofils (4b) der zwei vertikalen Trägerprofile (4a, 4b) geschwenkt werden kann und anschließend der federnde Längenausgleich (9) entspannt werden kann und die Rasteinrichtung mit einer der Öffnungen (3) am gegenüberliegenden anderen vertikalen Trägerprofil (4b) verrasten kann.

2. Varioträger (1) nach Anspruch 1,
**dadurch gekennzeichnet, dass**
der Varioträger (1) an den beiden Stirnseiten Haltehaken (2, 8) aufweist, die starr mit dem Varioträger (1) verbunden sind.

3. Varioträger (1) nach Anspruch 2,
**dadurch gekennzeichnet, dass**
die Haltehaken (2, 8) an der einen Stirnseite seitlich in eine Richtung greifen und die Haltehaken (2, 8) an der anderen Stirnseite seitlich in die Gegenrichtung greifen.

4. Varioträger (1) nach einem der Ansprüche 1 bis 3,
**dadurch gekennzeichnet, dass**
an einer Stirnseite des Varioträgers (1) die Rasteinrichtung angeordnet ist und an der gegenüberliegenden Stirnseite zumindest ein Zentrierelement angeordnet ist.

5. Varioträger (1) nach Anspruch 4,
**dadurch gekennzeichnet, dass**
das Zentrierelement als horizontale Lasche (5) ausgebildet ist und die der Rasteinrichtung gegenüberliegenden Haltehaken (2) vertikal in die Öffnungen (3) des einen vertikalen Trägerprofils (4a) eingreifen.

6. Varioträger (1) nach einem der Ansprüche 1 bis 5,
**dadurch gekennzeichnet, dass**
die Rasteinrichtung als Feder-Element (7) ausgebildet ist, das im verrasteten Zustand entspannt ist und an einem vertikalen Rand (3a, 3b) einer Öffnung (3) des anderen vertikalen Trägerprofils (4b) anschlägt.

7. Verfahren zur Montage eines Varioträgers (1) nach einem der Ansprüche 1 bis 6 an zwei vertikalen Trägerprofilen (4a, 4b) eines Racks,
**dadurch gekennzeichnet, dass**
- der Varioträger (1) so mit dem der Rasteinrichtung gegenüberliegenden Haltehaken (2) gerichtet auf ein erstes vertikales Trägerprofil (4a) gehalten wird, dass der Varioträger (1) in Draufsicht in einem spitzen Winkel zu einer imaginären Achse Y-Y' steht, die zwischen dem ersten vertikalen Trägerprofil (4a) und einem zweiten dem ersten gegenüberliegenden vertikalen Trägerprofil (4b) verläuft,
- der Haltehaken (2) in eine Öffnung (3) des ersten vertikalen Trägerprofils (4a) geführt und darin eingehängt wird,
- ein federnder Längenausgleich (9) am Varioträger (1) gespannt wird,
- der Varioträger (1) um den Haltehaken (2) in einer horizontalen Ebene in Richtung des zweiten vertikalen Trägerprofils (4b) geschwenkt wird, bis er kurz vor der imaginären Achse Y-Y' steht,
- der federnde Längenausgleich entspannt und die Länge des Varioträgers (1) verlängert wird, bis die Rasteinrichtung in eine Öffnung (3) des zweiten vertikalen Trägerprofils (4b) einrasten kann und
- die Rasteinrichtung in die Öffnung (3) des zweiten vertikalen Trägerprofils (4b) eingerastet wird.

8. Anordnung mit einem Varioträger (1) nach einem der Ansprüche 1 bis 6 und einem Rack mit zwei vertikalen Trägerprofilen (4a, 4b), wobei
- die vertikalen Trägerprofile (4a, 4b) des Racks Öffnungen (3) in einem standardisierten Raster aufweisen, und
- der Varioträger (1) über die Öffnungen (3) vermittels der Rasteinrichtung und des zumindest einen der Rasteinrichtung gegenüberliegenden Haltehakens (2) an den vertikalen Trägerprofilen (4a, 4b) festgelegt ist.

## Claims

1. Variable carrier (1) for the installation on two vertical carrier profiles (4a, 4b) of a rack, wherein
- the two vertical carrier profiles (4a, 4b) of the rack comprise openings (3) in a standardized grid,
- the variable carrier (1) can be secured to the vertical carrier profiles (4a, 4b) via the openings (3), and
- the variable carrier (1) comprises a snap-in device, which can be automatically snapped-into one of the openings (3) on the vertical carrier profiles (4a, 4b) during the installation,
**characterized in that**
the variable carrier (1) comprises
at least one retaining hook (2) rigidly connected to the variable carrier (1), opposite the snap-in device, for being hooked into one of the openings (3) of a vertical carrier profile (4a) of the two vertical carrier profiles (4a, 4b), such that the variable carrier (1) can be hooked into the opening (3) by means of the retaining hook (2), wherein the retaining hook (2), in the mounted state, engages laterally behind a vertical edge of the opening (3) provided to that end of the one vertical carrier profile (4a), and
- a resilient length compensation (9), wherein the resilient length compensation (9) can be tensioned and the variable carrier (1) can be pivoted about the retaining hook (2) in a horizontal plane in the direction of the opposite other vertical carrier profile (4b) of the two vertical carrier profiles (4a, 4b) and subsequently the resilient length compensation (9) can be relaxed and the snap-in device can snap into one of the openings (3) on the opposite other vertical carrier profile (4b).

2. Variable carrier (1) according to claim 1, **characterized in that**
the variable carrier (1) comprises retaining hooks (2, 8) at the two face sides, the retaining hooks rigidly connected to the variable carrier (1).

3. Variable carrier (1) according to claim 2, **characterized in that**
the retaining hooks (2, 8) engage laterally in one direction at one face side, and the retaining hooks (2, 8) engage laterally in the opposite direction at the other face side.

4. Variable carrier (1) according to any one of claims 1 to 3, **characterized in that**
the snap-in device is arranged at one face side of the variable carrier (1), and at least one centering element is arranged at the opposite face side.

5. Variable carrier (1) according to claim 4, **characterized in that**
the centering element is formed as a horizontal lug (5), and the retaining hooks (2) opposite the snap-in device engage vertically into the openings (3) of the one vertical carrier profile (4a).

6. Variable carrier (1) according to any one of claims 1 to 5, **characterized in that**
the snap-in device is formed as a spring element (7), which is relaxed in the snapped state, and abuts on a vertical edge (3a, 3b) of an opening (3) of the other vertical carrier profile (4b).

7. Method of mounting a variable carrier (1) according to any one of claims 1 to 6 on two vertical carrier profiles (4a, 4b) of a rack,
**characterized in that**
- the variable carrier (1) is held with the retaining hook (2), located opposite the snap-in device, directed to a first vertical carrier profile (4a) in such a way that the variable carrier (1), in a plan view, extends at an acute angle relative to an imaginary axis Y-Y' that extends between the first vertical carrier profile (4a) and a second vertical carrier profile (4b) located opposite the first one,
- the retaining hook (2) is guided into an opening (3) of the first vertical carrier profile (4a) and hooked therein,
- a resilient length compensation (9) on the variable carrier (1) is tensioned,
- the variable carrier (1) is pivoted around the retaining hook (2) in a horizontal plane in the direction of the second vertical carrier profile (4b), until it is situated just in front of the imaginary axis Y-Y',
- the resilient length compensation is relaxed and the length of the variable carrier (1) is extended, until the snap-in device can snap-into an opening (3) of the second vertical carrier profile (4b), and
- the snap-in device is snapped-into the opening (3) of the second vertical carrier profile (4b).

8. Arrangement with a variable carrier (1) according to any one of claims 1 to 6, and with a rack having two vertical carrier profiles (4a, 4b), wherein
- the vertical carrier profiles (4a, 4b) of the rack comprise openings (3) in a standardized grid, and
- the variable carrier (1) is secured to the vertical carrier profiles (4a, 4b) by means of the snap-in device and the at least one retaining hook (2) opposite the snap-in device.

## Revendications

1. Support variable (1) destiné au montage au niveau de deux profilés de support (4a, 4b) verticaux d'un rack, dans lequel
- les deux profilés de support (4a, 4b) verticaux du rack présentent des ouvertures (3) selon une trame standardisée,
- le support variable (1) peut être fixé par l'intermédiaire des ouvertures (3) au niveau des profilés de support (4a, 4b) verticaux, et
- le support variable (1) présente un dispositif d'enclenchement, lequel peut être enclenché de manière automatique lors du montage dans une des ouvertures (3) au niveau des profilés de support (4a, 4b) verticaux,
**caractérisé en ce que**
le support variable (1)
- présente, en vis-à-vis du dispositif d'enclenchement, au moins un crochet de maintien (2) relié de manière rigide au support variable (1), destiné à être suspendu dans une des ouvertures (3) d'un profilé de support (4a) vertical des deux profilés de support (4a, 4b) verticaux, de sorte que le support variable (1) peut être suspendu par l'intermédiaire du crochet de maintien (2) dans l'ouverture (3), dans lequel le crochet de maintien (2) s'engage dans l'état monté latéralement derrière un bord vertical de l'ouverture (3) prévue à cet effet de l'un profilé de support (4a) vertical et
- présente une compensation de longueur (9) sur ressorts, dans lequel la compensation de longueur (9) sur ressorts peut être tendue et le support variable (1) peut être pivoté autour du crochet de maintien (2) dans un plan horizontal en direction de l'autre profilé de support (4b) vertical faisant face des deux profilés de support (4a, 4b) verticaux et pour finir la compensation de longueur(9) sur ressorts peut être détendue et le dispositif d'enclenchement peut s'enclencher avec une des ouvertures (3) au niveau de l'autre profilé de support (4b) vertical faisant face.

2. Support variable (1) selon la revendication 1,
**caractérisé en ce que**
le support variable (1) présente au niveau des deux côtés frontaux des crochets de maintien (2, 8), qui sont reliés de manière rigide au support variable (1).

3. Support variable (1) selon la revendication 2,
**caractérisé en ce que**
les crochets de maintien (2, 8) s'engagent au niveau d'un côté frontal latéralement dans une direction et les crochets de maintien (2, 8) s'engagent au niveau de l'autre côté frontal latéralement dans le sens opposé.

4. Support variable (1) selon l'une quelconque des revendications 1 à 3,
**caractérisé en ce que**
le dispositif d'enclenchement est disposé au niveau d'un côté frontal du support variable (1) et au moins un élément de centrage est disposé au niveau du côté frontal faisant face.

5. Support variable (1) selon la revendication 4,
**caractérisé en ce que**
l'élément de centrage est réalisé sous la forme d'une patte (5) horizontale et les crochets de maintien (2) faisant face au dispositif d'enclenchement viennent en prise de manière verticale avec les ouvertures (3) d'un profilé de support (4a) vertical.

6. Support variable (1) selon l'une quelconque des revendications 1 à 5,
**caractérisé en ce que**
le dispositif d'enclenchement est réalisé sous la forme d'un élément ressort (7), qui est détendu dans l'état enclenché et vient buter au niveau d'un bord (3a, 3b) vertical d'une ouverture (3) de l'autre profilé de support (4b) vertical.

7. Procédé servant au montage d'un support variable (1) selon l'une quelconque des revendications 1 à 6 au niveau de deux profilés de support (4a, 4b) verticaux d'un rack,
**caractérisé en ce que**
- le support variable (1) est maintenu de telle sorte avec le crochet de maintien (2) faisant face au dispositif d'enclenchement de manière dirigée sur un premier profilé de support (4a) vertical que le support variable (1) se situe vu d'en haut selon un angle aigu par rapport à un axe imaginaire Y-Y', qui s'étend entre le premier profilé de support (4a) vertical faisant face et un deuxième profilé de support (4b) vertical faisant face au premier,
- le crochet de maintien (2) est guidé dans une ouverture (3) du premier profilé de support (4a) vertical et y est suspendu,
- une compensation de longueur (9) sur ressorts est tendue au niveau du support variable (1),
- le support variable (1) est pivoté autour du crochet de maintien (2) dans un plan horizontal en direction du deuxième profilé de support (4b) vertical jusqu'à ce qu'il se trouve peu avant l'axe imaginaire Y-Y',
- la compensation de longueur sur ressorts est détendue et la longueur du support variable (1) est allongée jusqu'à ce que le dispositif d'enclenchement puisse s'enclencher dans une ouverture (3) du deuxième profilé de support (4b) vertical, et
- le dispositif d'enclenchement est enclenché dans l'ouverture (3) du deuxième profilé de support (4b) vertical.

8. Ensemble avec un support variable (1) selon l'une quelconque des revendications 1 à 6 et un rack avec deux profilés de support (4a, 4b) verticaux, dans lequel
- les profilés de support (4a, 4b) verticaux du rack présentent des ouvertures (3) selon une trame standardisée, et
- le support variable (1) est fixé par l'intermédiaire des ouvertures (3) par l'entremise du dispositif d'enclenchement et de l'au moins un crochet de maintien (2) faisant face au dispositif d'enclenchement au niveau des profilés de support (4a, 4) verticaux.
